**Europäisches Patentamt**

**European Patent Office**

**Office européen des brevets**

(19)

(11) Veröffentlichungsnummer: **0 315 228 B1**

(12) # EUROPÄISCHE PATENTSCHRIFT

(45) Veröffentlichungstag der Patentschrift:
04.12.91 Patentblatt 91/49

(51) Int. Cl.⁵: **H05K 3/34**, B23K 1/00,
H05K 13/04

(21) Anmeldenummer: **88201977.1**

(22) Anmeldetag: **08.09.88**

(54) Lötvorrichtung.

Verbunden mit 88907314.4/0391903
(europäische
Anmeldenummer/Veröffentlichungsnummer)
durch Entscheidung vom 10.04.91.

(30) Priorität: **04.11.87 DE 3737457**

(43) Veröffentlichungstag der Anmeldung:
**10.05.89 Patentblatt 89/19**

(45) Bekanntmachung des Hinweises auf die
Patenterteilung:
**04.12.91 Patentblatt 91/49**

(84) Benannte Vertragsstaaten:
**AT BE CH DE ES FR GB IT LI LU NL SE**

(56) Entgegenhaltungen:
**EP-A- 0 233 125
DE-A- 2 343 235
DE-B- 1 279 150
GB-A- 2 098 133
US-A- 3 586 813
US-A- 4 156 124**

(73) Patentinhaber: **Gammelin, Peter
Im Binzig 14
W-6948 Wald-Michelbach (DE)**

(72) Erfinder: **Gammelin, Peter
Im Binzig 14
W-6948 Wald-Michelbach (DE)**

(74) Vertreter: **Weber, Otto Ernst, Dipl.-Phys. et al
Weber & Heim Hofbrunnstrasse 36
W-8000 München 71 (DE)**

**Beschreibung**

Die Erfindung betrifft eine Vorrichtung zum Herstellen oder Lösen von Lötverbindungen zwischen einem mit mehreren Anschlüssen versehenen elektronischen Bauelement, z.B. SMD-Bauelement, und einem Bauelementträger, mit einer in Abstand von der Lötverbindung angeordneten Wärmequelle, mittels welcher ein Warmluftstrahl und/oder ein Infrarotstrahl auf die Lötverbindung gerichtet ist und mit einer Maske zur Begrenzung dieses Strahls.

Bekanntlich bestehen elektronische Baugruppen aus einem mit Leiterbahnen versehenen starren oder flexiblen Träger, auf welchem elektronische Bauelemente aufgelötet sind. Es sind sowohl Bauelemente mit steckbaren Anschlußstiften für eine sogenannte Steckmontage bekannt, die im Träger in Befestigungslöchern sowie in Löchern zur Durchkontaktierung verlötet sind, als auch Bauelemente, die unmittelbar auf die Oberfläche der Leiterbahnen zur mechanischen und elektrischen Verbindung aufgelötet sind. Die Leiterbahnen müssen hierbei also nicht zur Aufnahme eines jeden Bauelements durchbrochen oder durchbohrt werden. Diese letztgenannte Tecknik ist als Oberflächenmontage (Surface Mounted Assembly) bekannt. Für besondere Anwendungsbereiche ist eine Mischbestückung mit steck- und oberflächenmontierten Bauelementen ebenfalls üblich.

Für die Oberflächenmontage werden spezielle SMD-Bauelemente (Surface Mounted Devices) entwickelt, beispielsweise Widerstände, Kondensatoren, Dioden, Transistoren, integrierte Schaltungen und Chipträger. Diese Bauelemente haben im Unterschied zu den mit Stiftanschlüssen versehenen Bauelementen Anschlußflächen oder kurze Kontaktbeinchen, die unmittelbar, d.h. ohne Anschlußdrähte, auf der Leiterplatte verlötet werden.

Eine für die SMA-Tecknik anwendbare Lötmethode ist das sogenannte Reflow-Löten, wobei als Wärmequelle häufig ein Heißgasfön eingesetzt wird. Der auf die Lötstelle gerichtete Heiß-Lufstrahl bringt das dort aufgebrachte Lötzinn oder eine Lötpaste zum Schmelzen.

Zur Herstellung insbesondere von SMA-Baugruppen werden automatische Bestückungsmaschinen eingesetzt, die große Stückzahlen ermöglichen. Die Anschaffungs- und Betriebskosten dieser Automaten sind allerdings so hoch, daß kleine Stückzahlen nicht wirtschaftlich verarbeitet werden können.

Unter Anwendung des Reflow-Lötens sind zur Fertigung von Kleinserien, zur Mischbestückung, zur Bestückung oder Modifikation von einzelnen Leiterplatten oder zum Austausch einzelner Bautele Vorrichtungen bekannt, bei welchen die Heißluft über Düsen auf das betreffende Bauelement geblasen wird. Zwar kann die Strahlführung durch unterschiedliche, austauschbare Düseneinsätze an verschiedene Bauelementeformen angepaßt werden, es kann allerdings vorkommen, daß wegen der großen Streuung des Lufstrahls das gesamte Bauelement im Heißluftstrahl liegt und insgesamt aufgeheizt wird. Durch die ungleichmäßige Wärmeabsorption in den unterschiedlichen Bauelementmaterialien wie Metall, Keramik und Kunststoff, besteht dabei die Gefahr, daß Wärmespannungen und Haarrisse auftreten, welche die Funktionssicherheit nachteilig beeinflussen können. Ferner sind angesichts der Vielfalt von Bauelementeformen die Anschaffung und Vorhaltung einer großen Zahl von Düseneinsätzen erforderlich. Außerdem ist der Einsatwechsel mit relativ großen Umrüstzeiten verbunden.

Aus EP-A-0233125 und DE-B-1279150 sind gattungsgemäße Vorrichtungen zum Lösen und Herstellen von Lötverbindungen zwischen elektronischen Bauelementen und einem Bauelementträger bekannt, bei denen ein Heißluftstrahl auf die Lötverbindung gerichtet ist und eine Maske zur Begrenzung des Heißluftstrahls verwendet wird. Diese bekannte Vorrichtung weist außerdem einen bewegbaren Maskenträger auf. Er wird durch die Aufnahme des Gehäuses gebildet, das querverschieblich über dem Bauelementträger angebracht ist.

Der Erfindung liegt die Aufgabe zugrunde, eine Erfindung der eingangs genannten Art anzugeben, welche eine präzise Beaufschlagung der Lötverbindungen und der Bauelementeanschlüsse ermöglicht, ohne die übrigen Bauelemente unmittelbar thermisch zu belasten, und welche außerdem einfach und schnell handhabbar ist.

Diese Aufgabe wird alternativ gemäß dem kennzeichnenden Teil des Anspruchs 1 oder des Anspruchs 4 gelöst.

Ein Grundgedanke der Erfindung besteht darin, den Heizstrahl in einzelne Teilstrahlen aufzuteilen und diese lagegenau auf die Anschlußflächen, Anschlußbeinchen oder Anschlußstifte zu richten, so daß die Erhitzung ausschließlich auf diese Stellen beschränkt ist. Da die Maske im Verhältnis 1 : 1 zu den tatsächlichen Bauelementeabmessungen hergestellt werden kann, wird eine äußerst präzise Strahlführun erreicht. Grundsätzlich braucht die Maske nich auf ein einzelnes Bauelement beschränkt zu sein. Selbstverständlich kann auch eine Konfiguration mit mehreren Elementen berücksichtigt sein.

Das Auswechseln von Masken erfolgt auf einfache Weise und Zeitsparend dadurch, daß mehrere Masken auf einem flexiblen Streifen angeordnet sind, und daß eine Auf- und eine Abwickelrolle für den flexiblen Streifen vorhanden sind. Die Anordnung des Streifens auf Rollen hat auch den Vorteil, daß eine Vielzahl von unterschiedlichen Masken besonders raumsparend untergebracht sind. Alternativ dazu kann es auch zweckmäßig sein, daß mehrere Masken auf einer Drehscheibe angeordnet sind. Durch diese Maßnahme können besonders kurze Zugriffszeiten erreicht werden. Als flexibles Maskenmaterial ist besonders kupferkaschierte Kaptonfolie oder Dünnblech geeignet. Beim erstegenannten Material kann die Lochkonfiguration besonders einfach durch photochemische Verfahren hergestellt werden, wie sie zur Herstellung von Leiterplatten bekannt sind. Das Dünnblech kann durch Ausstanzen, Ausbohren oder Laserschneiden bearbeitet werden.

Darüberhinaus ist auch Keramikmaterial geeignet, welches den Vorteil hat, daß es mit relativ einfachen Mitteln bearbeitet werden kann. Es kann auch zweckmäßig sein, das Auswechseln von Einzelmasken mit Hilfe eines Wechselrahmens zu bewerkstelligen der in einer Schiebeführung in die gewünschte Position gebracht wird.

Die Zuordnung und Auswahl der einzelnen Masken zu den aktuell zu bearbeitenden Bauelementen wird dadurch erleichtert, daß jede Maske mit einer Identifizierungsmarke versehen ist, und daß die Vorrichtung mit einer Wiedergabe-/Lesevorrichtung für die Marke versehen ist. Das Identifizieren der einzelnen Masken kann sowohl durch eine Bedienperson als auch durch einen elektro-optischen Leser erfolgen.

Ein im wesentlichen selbsttätiger Maskenwechsel wird dadurch ermöglicht, daß ein Schrittmotor vorhanden ist, welcher mit der Lesevorrichtung und einer elektronischen Steuerung zusammenwirkt. Eine sehr gute Strahlführung wird bereits dadurch erreicht, daß als Heizelement ein an sich bekannter Heißluftfön eingesetzt wird. Eine impulsartige Beaufschlagung mit Heißluft kann dadurch erreicht werden, daß als Wärmeträger erhitzte Druckluft verwendet wird, die auch eine besonders genau begrenzte Wärmebeaufschlagung gewährleistet.

Die Aufheizung eines als Wärmeträger dienenden Gases erfolgt zweckmäßigerweise in einer Heizkammer mit einem Heizelement, bestehend aus einem Steg mit beidseitig angeordneten Rippen, in welchen mehrere zylindrische Heizstäbe eingesteckt sind. Wenn das Heizelement auch als Wärmespeicher dienen soll, so wird es bevorzugt auf Metall gefertigt. Stattdessen ist es im Hinblick auf eine kurze Ansprechzeit und zur Energiesparung vorteilhaft, daß das Heizelement aus Keramikmaterial hergestellt ist.

Anstelle der eingesteckten Heizstäbe kann es bei diesem Material auch zweckmäßig sein, daß Heizwendeln auf das Material aufgelegt oder aufgedruckt sind. Mit Hilfe des Sinterverfahrens ist eine vielfältige Formgebung und Verteilung der Heizwendeln möglich.

Zur Regulierung der Heizung werden bevorzugt mehrere unabhängig ansteuerbare Heizdrähte vorgesehen. Den jeweiligen Anforderungen entsprechend, die material- oder baugruppenabhängig sein können, wird die Anzahl der geheizten Drähte variiert.

Um zu verhindern, daß das Gehäuse als Wärmespeicher wirkt, und zur Verkürzung der Ansprechzeit, wird vorgeschlagen, daß das Gehäuse thermisch isoliert ist. Auf besonders einfache Weise wird dies dadurch erreicht, daß das Gehäuse aus Keramikmaterial hergestellt ist. Dieser Werkstoff ist darüber hinaus mechanisch leicht zu bearbeiten.

Die lagegenaue Positionierung der Bauelemente unter der Maske wird dadurch vereinfacht, daß hinter der Maske eine Lichtquelle angeordnet ist, so daß die Maskenposition durch eine Lichtmarke angezeigt ist. Grundsätzlich ist es nicht erforderlich, daß für die Lichtmarkierung zusätzliche Öffnungen in der Maske vorhanden sind. Vielmehr tritt das Licht durch dieselben Maskenöffnungen aus wie der Wärmestrahl. Die Lichtmarkierungen sind daher identisch mit der vom Wärmestrahl beaufschlagten Fläche. Werden daher die betreffenden Bauelementeanschlüsse in Deckung mit den Lichtmarkierungen gebrcht, so ist das Bauelement richtig positioniert. Somit sind besonders Arbeiten an Einzelteilen außerordentlich rationell, ohne daß aufwendige Positionierungsvorrichtungen erforderlich sind.

In konstruktiver Hinsicht ist es besonders einfach, daß die Lichtquelle, ein mit Rippen oder Durchbrüchen versehenes Heizelement, und die Maske in einer Linie angeordnet sind. Das Heizelement bewirkt hierbei eine Lichtstreuung, so daß gleichmäßiges, diffuses Licht aus der Maske austritt, was besonders gut zur Positionsanzeige geeignet ist.

Es kann sich auch als vorteilhaft erweisen, daß die Lichtquelle seitlich neben dem Heizelement angeordnet ist. In allen Fällen erweist es sich auch als vorteilhaft, daß vor der Maske eine Lichtkammer vorhanden ist, in welcher das Licht gestreut wird. Diese Kammer hat somit den Effekt einer Streuscheibe, ohne daß der Durchtritt des Heizstrahl behindert wird. Das Licht kann in diese Streukanner auch über lichtleitende Materialien geleitet werden.

Wird als Wärmequelle anstelle eines Heizelementes über welche ein Gas geleitet wird, ein Infrarotstrahler eingesetzt, so besteht ein weiterer Vorteil der Erfindung darin, daß die Positionierung mit Hilfe der aus der Maske austretenden IR-Strahlen ohne zusätzlichen konstruktiven Aufwand vorgenommen werden kann.

Eine alternative Lösung und vorteilhafte Weiterbildungen sind in Anspruch 4 bzw. den darauf rückbezogenen Ansprüchen beschrieben.

Nachfolgend wird die Erfindung anhand von drei in der Zeichnung dargestellten Ausführungsbeispielen weiter beschrieben.

Fig. 1      zeigt in perspektivischer Ansicht eine Explosionsdarstellung einer ersten Lötverrichtung ;

Fig. 2      zeigt schematisch eine perspektivische Ansicht einer Maske zur Verwendung in der ersten Lötvorrichtung gemäß Fig. 1 ;

Fig. 3      zeigt schematisch einen perspektivischen Vertikal-Längsschnitt durch eine zweite Lötvorrichtung ;

Fig. 4      zeigt schematisch einen Vertikal-Querschnitt durch die zweite Lötvorrichtung ;

Fig. 5      zeigt schematisch eine perspektivische Ansicht eines Heizelementes ;

Fig. 6      zeigt schematisch eine dritte Lötvorrichtung ;

Fig. 7 bis 9      zeigen schematisch jeweils ein Beispiel einer Maske.

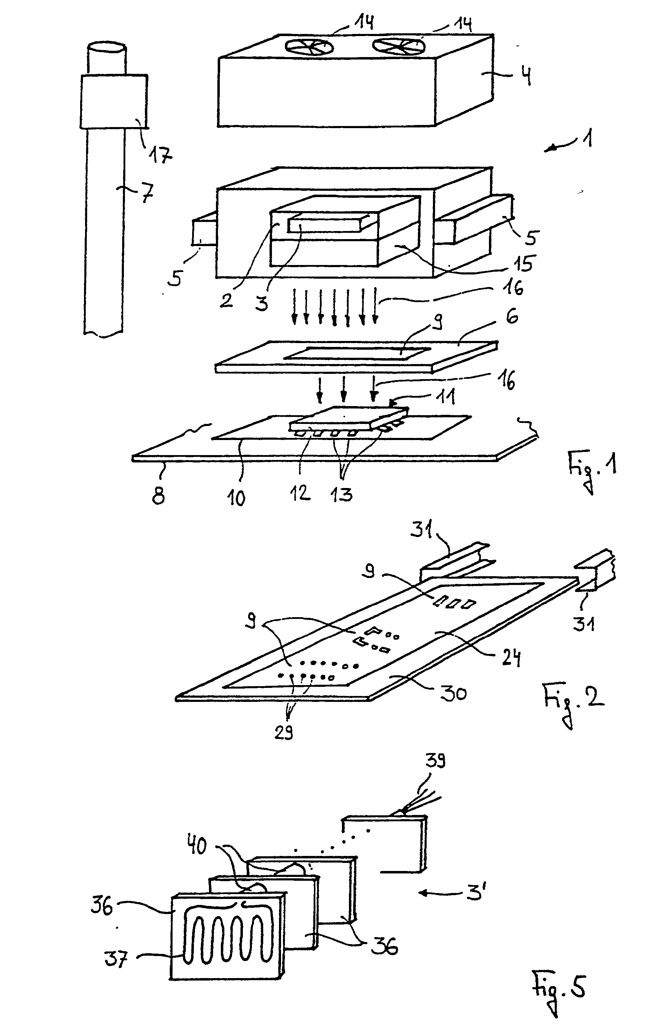

Eine in ihrer Gesamtheit mit 1 bezeichnete Lötvorrichtung umfaßt gemäß Fig. 1 eine Wärmequelle, die aus einer Heizkammer 2 mit Heizelementen 3 besteht, einen Lüfter 4, zwei Lichtquellen 5, eine Maskenhalterung 6 sowie ein höhenverstellbares Stativ 7, mit welcher die Lötvorrichtung 1 relativ zu einem in einer Ebene verfahrbaren Schlitten 8 höhenverschieblich gelagert ist. In der Maskenhalterung 6 befindet sich eine Maske 9 aus temperaturbeständigem Material.

Auf dem Schlitten 8 ist in bekannter Weise ein Baugruppenträger 10 mit elektronischen Bauelementen befestigt. Um die Darstellung anschlaulich zu halten, ist auf dem Träger lediglich ein einziges Bauelement in starker Vergrößerung eingezeichnet. Es besteht aus einem quaderförmigen Kunststoff- oder Keramikörper 12, welcher eine elektronische Schaltung aufnimmt, und aus einer Vielzahl von metallischen Anschlußbeinchen 13, mit welchen das Bauelement 11 auf die Oberfläche des Baugruppenträgers 10 aufgesetzt ist. Es handelt sich hierbei um eine grundsätzlich bekannte Konfiguration, die als SMD-Baugruppe bezeichnet wird.

Über den Lüfter 4, der aus einem oder mehreren Radiallüftern 14 besteht, wird Außenluft oder ein Schutzgas angesaugt und in der Heizkammer an den Heizelementen 3 vorbeigeleitet. An die Heizkammer 2 schließt sich in Flußrichtung eine Streukammer 15 an, an deren Ausgang sich die Maskenhalterung 6 mit der Maske 9 befindet. Die Heißluft tritt daher ausschließlich über die Maske 9 aus. Die Maske 9 enthält die exakten Positionen der Lötflächen zwischen dem Bauelement 11 und dem Baugruppenträger 10 in Form von Bohrungen, Schlitzen oder einer Gesamtkontur. Anders ausgedrückt bedeutet dies, daß die Maskenöffnungen ein genaues Abbild der Anschlußbeinchenkonfiguration des Bauelements 11 darstellen. Da sich die Heißluft nach dem Austritt aus der Maske 9 im wesentlichen geradlinig und strahlförmig bewegt, treffen die einzelnen Heißluftstrahlen bei entsprechend genauer Positionierung der Lötvorrichtung 1 exakt auf die Lötflächen an den Anschlußbeinchen 13.

Die Positionierung wird dadurch erleichtert, daß über die Lichtquellen 5 Licht in die Streukammer 15 in der Weise geleitet wird, daß diese als ungerichtete, gleichmäßig abstrahlende Lichtquelle dient. Durch die Öffnungen der Maske 9 treten parallel verlaufende Lichtstrahlen aus, die genau senkrecht zum Schlitten 8 bzw. zum Baugruppenträger 10 ausgerichtet sind. Der Verlauf der Lichtstrahlen 16 ist identisch mit den austretenden Heißluftstrahlen.

Die Lichtstrahlen 16 bilden Leuchtflecken auf dem Bauelement 11 bzw. auf dem Baugruppenträger 10, so daß durch eine Seitwärtsverschiebung des Schlittens 8 eine lagegenaue Positionierung der Anschlußbeinchen 13 unterhalb der Maske 9 erfolgen kann.

Die Lötvorrichtung 1 wird möglichst dicht über dem Bauelement 11 angeordnet, indem sie über einen am Stativ 7 geführten Schlitten 17 vertikal verschoben wird.

In den nachfolgenden Figuren sind gleiche Teile wie in Fig. 1 mit gleichen Bezugszeichen versehen.

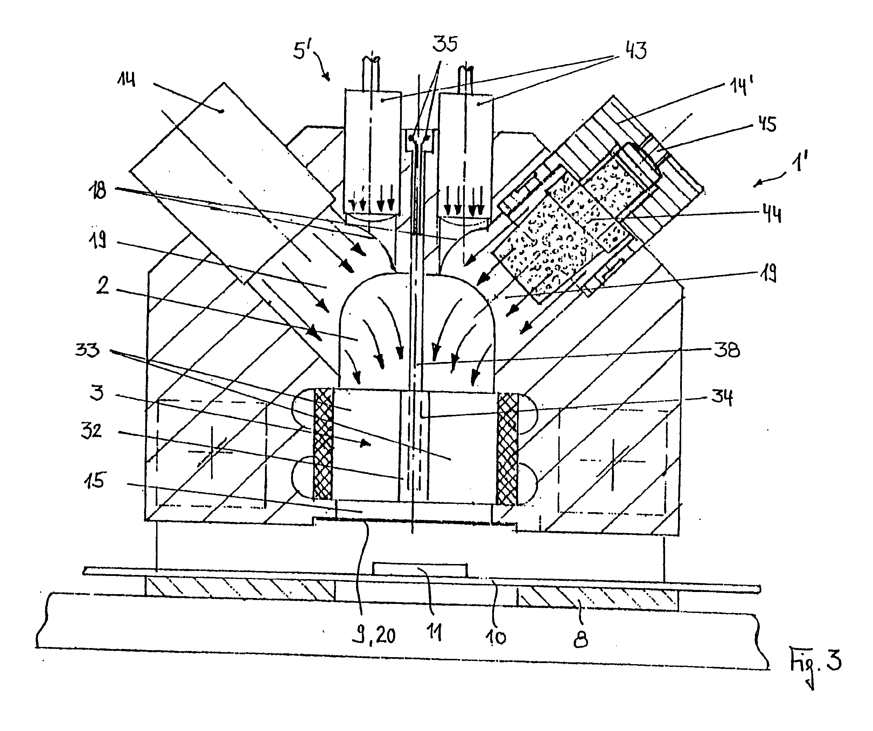

Fig. 2 zeigt in perspektivischer Ansicht einen Streifen 24 aus einer hitzebeständigen Folie mit mehreren Masken 9. Die Löcher 29 der einzelnen Masken entsprechen maßstabsgetreu der Anordnung von Anschlußbeinchen unterschiedlicher Bauelemente. Der Streifen 24 ist in einem starren Rahmen 30 gehalten, so daß er in eine Schiene 31 eingesteckt und dort zur Positionierung der einzelnen Masken 9 verschoben werden kann. Die Schiene 31 ist Bestandteil der Maskenhalterung 6 gemäß Fig. 1.

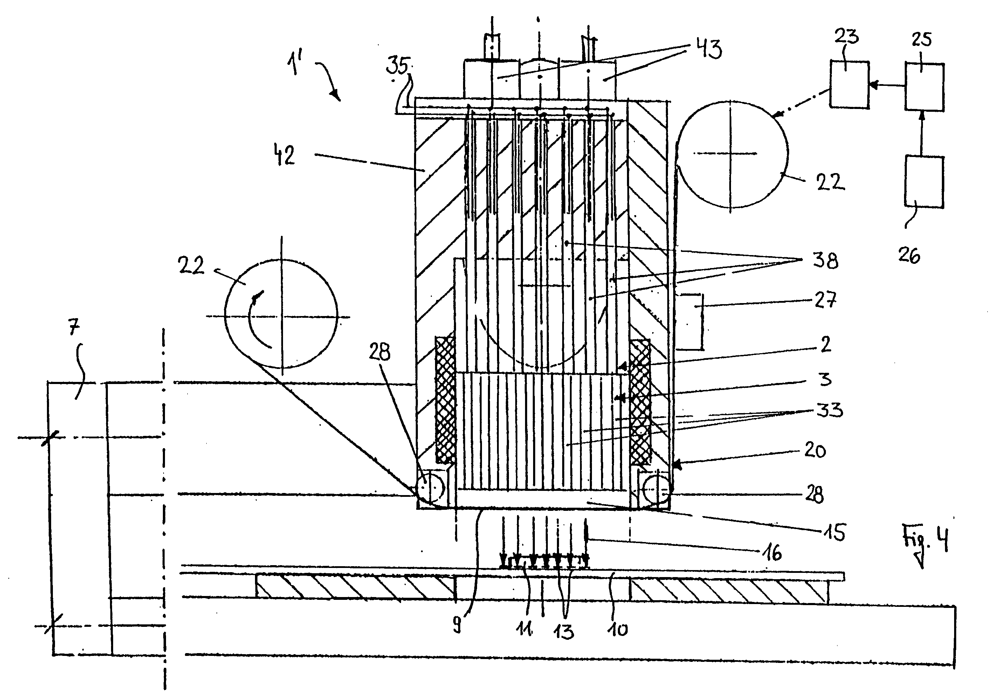

Fig. 3 zeigt in einem Vertikal-Längsschnitt eine zweite Lötvorrichtung 1', die sich in konstruktiven Einzelheiten von der Lötvorrichtung 1 gemäß Fig. 1 unterscheidet. In dem hier dargestellten Beispiel besteht die Lichtquelle 5' aus mehreren Halogen-Strahlern 43, die oberhalb der Heizkammer 2 angeordnet sind. Die Halogen-Strahler 43 sind an der Lichtaustrittseite jeweils über eine lichtdurchlässige Streuscheibe 18, beispielsweise aus hitzebeständigem Milchglas, von der darunter liegenden Heizkammer 2 getrennt.

Die Heizelemente 3 schatten dabei die Lichtquelle 5 zwar teilweise ab ; durch die zahlreichen Lichtablenkungen und Reflexionen an den Heizelementen 3 und den Wänden der Heizkammer 2 wird dennoch eine zur Positionierung des Bauelementes 11 ausreichende gleichmäßige Lichtstärke erreicht.

Die Radiallüfter 14 sind bei dieser Ausführungsform unter einer gewissen Neigung seitlich oberhalb der Heizkammer 2 angeordnet. Die angesaugte Luft gelangt über Kanäle 19 in die Heizkammer 2, wobei auch die Streuscheiben 18 als Leitfläche dienen und zur Unterstützung dieser Funktion konvex ausgeformt sind.

Die Fig. 3 zeigt auf der linken Seite einen herkömmlichen Radiallüfter. Auf der rechten Seite ist im Querschnitt eine Alternative 14' gezeigt, die verwendet werden kann, wenn Druckluft in die Heizkammer 2 eingeleitet werden soll. Sie weist einen Schlauchanschluß 45 für eine externe Druckluftquelle (nicht dargestellt) auf. Diesem folgt in Stromrichtung ein Einsatz 44 aus porösem Sintermetall zur Druckluftverteilung.

Die Heizelemente 3 bestehen aus einem quaderförmigen Keramikkörper mit einem zentralen Längssteg 32, der senkrecht zur Zeichenebene verläuft. Er trägt beidseitig mehrere Rippen 33, an welchem die angesaugte Luft vorbeiströmt. Im Steg befinden sich mehrere zylindrische Ausnehmungen 34, welche jeweils einen Heizstab 38, bestehend aus einem Heizdraht 35, der in ein Keramikrohr eingebrannt ist, aufweisen. Die Heizstäbe 38 können auf einfache Weise ausgetauscht werden.

Die Maske 9 befindet sich zusammen mit einer Vielzahl anderer Masken, deren Lochkonfiguration sich jeweils mit den Lötflächen verschiedener Bauelemente deckt, auf einer flexiblen Folie 20, beispielsweise einer kupferkaschierten Kaptonfolie oder einer Blechfolie. Durch eine Bewegung der Folie 20 senkrecht zur Zeichenebene können unterschiedliche Masken in die Betriebsposition unterhalb der Heizkammer 2 gebracht werden.

Grundsätzlich könne auf einer derartigen Folie ausreichend viele unterschiedliche Masken vorhanden sein, und es können dabei sowohl hersteller- als auch anwenderspezifische Lochkonfigurationen berücksichtigt sein.

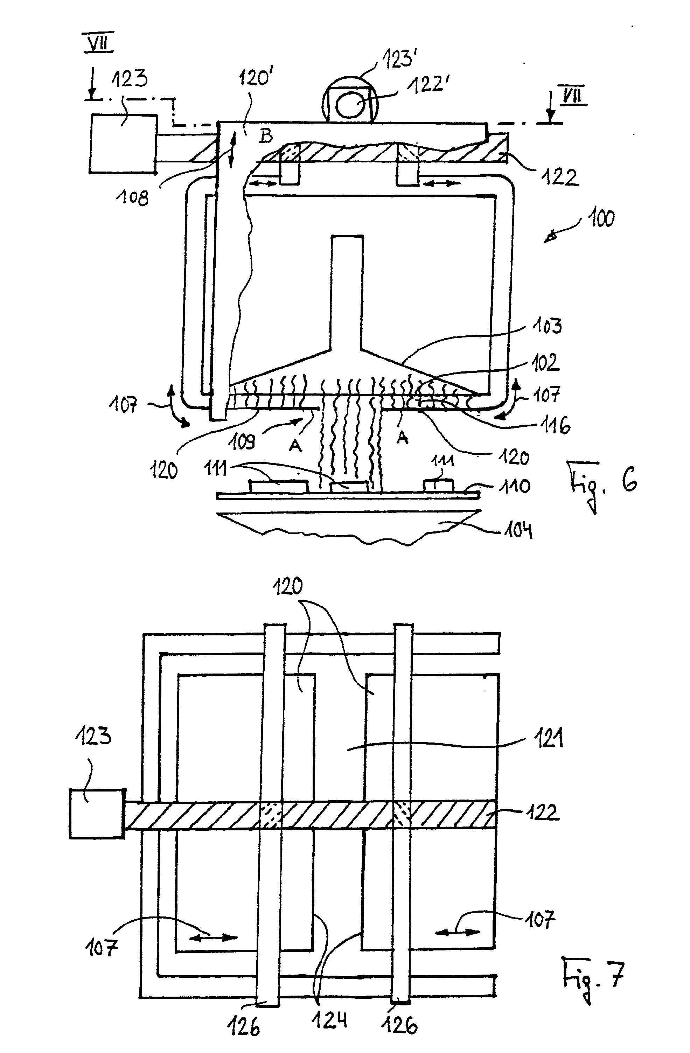

Wie die Fig. 4 zeigt, ist die Folie 20 auf einer Aufwickel-und einer Abwickelspule 22 enthalten. Die beiden Spulen 22 können in der Weise ausgebildet sein, daß sei von einer Bedienperson von Hand betätigt werden, beispielsweise über Rändelmuttern (nicht dargestellt), die drehfest mit den beiden Spulen 22 verbunden sind. Alternativ dazu kann auch ein motorbetriebener Antrieb vorhanden sein. Der Motorantrieb, der bevorzugt einen Schrittmotor 23 umfaßt, wird von einer Bedienperson über eine Tasteneingabe 26 und eine nachgeschaltete Steuereinheit 25 angesteuert. Mit einer opto-elektronischen Leseeinrichtung 27, deren Sensor beispielsweise aus einer Diodenzeile besteht, wird diejenige Maske 9 ermittelt, die sich in der Arbeitsposition unterhalb der Heizkammer 2 befindet. Eine entsprechende Kodierung ist zu diesem Zweck auf der Folie 20 angebracht. Zusätzlich können auch unverschlüsselte Informationen auf der Folie angebracht sein, die von einer Bedienperson an einem Fenster abgelesen werden können, an welchem die Folie 20 vorbeigeführt wird. Insbesondere bei einer manuellen Verstellung der Auf-/Abwickelspulen 22 ist eine derartige Anziegeeinrichtung hilfreich.

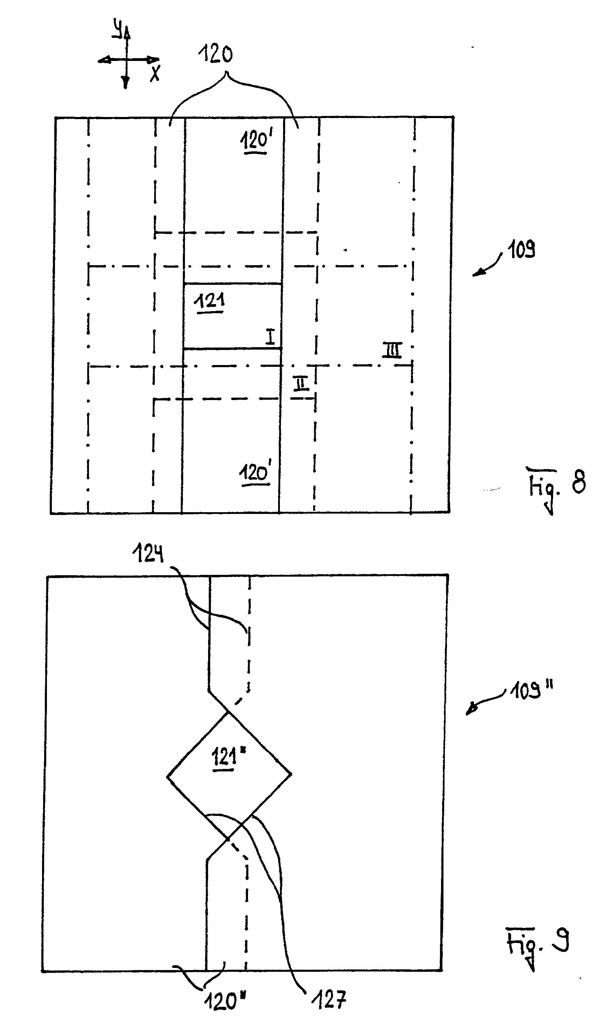

Zur Führung der Folie 20 sind Umlenkrollen 28 am Gehäuse 42 vorhanden. Ein alternatives Heizelement 3' zu dem in den vorhergenden Figuren gezeigten Heizelement 3 veranschaulicht Fig. 5 in perspektivischer Ansicht. Es besteht aus mehreren parallel zueinander angeordeneten Keramikplatten 36, auf welche jeweils eine Heizwendel 37 im Dick- oder Dünnfilmverfahren eingebrannt wurde. Die Keramikplatten 36 sind über Abstandshalter 40 miteinander verbunden und zu einer Einheit zusammengefaßt. Die Anschlüsse 39 der einzelnen Heizwendeln sind im Innern der Abstandshalter 40 nach außen geführt, so daß sie unabhängig voneinander eingeschaltet werden können.

Eine weitere Alternative einer Lötvorrichtung 100 ist in Fig. 6 dargestellt. Die Wärmequelle besteht hierbei aus einem Infrarotstrahler 103 mit einem großflächigen, nach unten auf eine Leiterplatte 110 gerichteten Strahlungsaustritt 102. Die schematisch wiedergegebenen Infrarotstrahlen sind mit 116 bezeichnet. Der Strahlungsaustritt 102 wird durch eine stufenlos verstellbare Maske 109 wahlweise begrenzt. Zu diesem Zweck besteht die Maske 109 aus mehreren verschiebbaren Blenden 120, die paarweise angeordnet sind. Sie bestehen aus einem dünnen, flexiblen und wärmebeständigen metallischem Folienmaterial. Um Wärmeableitungen zu verringern, weisen sie ferner einen schlechten Wärmeleitwert auf. Als gut geeignet erweisen sich Folien mit einer Stärke von etwa 0,1 mm. Ein erstes Paar A wird gemäß Pfeil 107 von oben bis vor den Strahlenaustritt 102 um den Strahler 103 herumgeführt. Ein zweites Paar B, von dem lediglich eine Blende 120 teilweise wiedergegeben ist, wird quer dazu gemäß Pfeil 108 verschoben.

Die Blenden 120, 120' werden paarweise gegensinnig mittels Schrittmotoren 123 bzw. 123' und quer zueinander ausgerichteten Spindelantrieben 122 bzw. 122' geöffnet oder geschlossen.

Unterhalb der Leiterplatte 110 befindet sich ein weiterer Infrarotstrahler 104, der auf die Plattenunterseite gerichtet ist. Damit werden die Lötpunkte auf der Plattenoberfläche bis zu einer vorgegebenen Temperatur vorerwärmt, die unterhalb einer für die Bauelemente 111 kritischen Temperatur liegt. Die zum Löten/Entlöten der Bauelemente 111 erforderliche zusätzliche Wärme wird gezielt über den Infrarotstrahler 103 zugeführt.

Wie die Fig. 6 bis 9 veranschaulichen, sind die Blenden 120, 120' paarweise in der Weise angeordnet, daß sie bei einer antiparallelen Bewegung ein Maskenfenster 121, 121" entweder vergrößern oder verkleinern, indem ihre Ränder 124 aufeinander zu bzw. voneinander weg bewegt werden. Dies wird dadurch erreicht, daß die Antriebswelle der Spindelantriebe 122, 122' über gegenläufige Gewinde mit zwei den beiden Blenden 120, 120' zugeordneten Blendenbefestigungen 126 in Eingriff steht. Die Blenden 120, 120' sind im übrigen in horizontalen Schienen oder Nuten geführt, die in Bewegungsrichtung seitlich neben dem Strahlungsaustritt 102 angeordnet sind.

Fig. 7 zeigt eine teilweise geschnittene Draufsicht auf die Lötvorrichtung 100 gemäß Linie VII-VII in Fig. 6. Um die Figur übersichtlich zu halten, ist der Infrarotstrahler 103 in der Figur nicht dargestellt, so daß die Ränder 124 der Blende 120 uneingeschränkt sichtbar sind. Werden die horizontalen Blendenbefestigungen 126 beispielsweise nach außen bewegt, so bewegen sich die Ränder 124 nach innen und verkleinern das Maskenfenster 121.

Um die Darstellung übersichtlich zu halten, ist in Fig. 7 lediglich ein einziges, antiparallel bewegbares Paar Blenden 120 und zugehöriger Schrittmotor 123/Spindelantrieb 122 wiedergegeben. Würde man in der Praxis lediglich ein derartiges Blendenpaar mit parallelen Rändern 124 vorsehen, so wäre die Größe des Maskenfensters 121 lediglich in einer Richtung veränderbar.

Um jedoch sowohl in Längs- als auch in Querrichtung regulieren zu können, ordnet man gemäß Fig. 8 ein weiteres Blendenpaar 120' an, wobei die Bewegungsrichtungen der beiden Blendenpaare 120, 120' quer zueinander ausgerichtet sind. Die Betätigung und Verstellung eines jeden Blendenpaares erfolgt unabhängig voneinander mit jeweils einem eigenen Schrittmotor und Spindelantrieb, sinngemäß in der in Fig. 6, 7 gezeigten Weise.

Durch beliebige, stufenlose Verschiebung sowohl in X- als auch in Y-Richtung lassen sich exakt vorgebbare Maskenfenster 121 einstellen. Das Maskenfenster ist hierbei immer mittig zum Strahlungsaustritt 102. Durch die unabhängige Ansteuerung der paarweise angeordneten Blenden 120, 120' kann wahlweise eine quadratische oder rechteckige Fensterform eingestellt werden, so daß das Maskenfenster 121 ohne weiteres an die Konturen der Bauelemente 111 (Fig. 1) angepaßt werden kann. Es ist also kein fest vorgegebener Maskensatz erforderlich, was insbesondere auch im Hinblick auf zukünftige Bauelemente-Konfigurationen vorteilhaft ist.

In Fig. 8 sind beispielhaft drei unterschiedliche Positionen I, II und III der beiden in Längs- bzw. in Querrichtung verschiebbaren, paarweise angeordneten Blenden 120, 120' wiedergegeben.

In Fig. 9 ist ein Beispiel für eine stufenlos verstellbare Maske 109″ veranschaulicht, die aus zwei antiparallel verschiebbaren Blenden 120″ besteht. Die das Maskenfenster 121″ bestimmenden Ränder 124 der Blenden 120″ verlaufen hierbei nicht über ihre gesamte Breite in einer Richtung parallel zueinander.

Sie sind vielmehr symmetrisch zur in Bewegungsrichtung verlaufenden Mittenachse mit nach vorne offenen Einschnitten 127 in der Weise versehen, daß sich die Einschnitte 127 der beiden betreffenden Blenden 120″ zum rechteckigen Maskenfenster 121″ ergänzen. Selbstverständlich kann der Einschnitt 127 auch eine andere geometrische Form aufweisen, wenn dies zur Anpassung an die zu bearbeitenden Bauelemente zweckmäßig ist. Durch eine antiparallele Bewegung der beiden Blenden 120″ erfolgt eine zweidimensionale Vergrößerung oder Verkleinerung des Maskenfensters 121″.

Wird die in Fig. 9 in ihrem Grundgedanken beschriebene, aus zwei Blenden 120″ bestehende Maske 109″ mit einem weiteren Blendenpaar kombiniert, das in Querrichtung hierzu bewegbar ist, so kann die Form des Maskenfensters 121″ noch weiter variiert werden.

Bei einem rechnergestützten Betrieb ist es möglich, standardisierte Bauteilgrößen abzuspeichern und dann die einzelnen Schrittmotore 123 programmgesteuert zu betätigen.

## Patentansprüche

1. Vorrichtung zum Herstellen oder Lösen von Lötverbindungen zwischen einem mit mehreren Anschlüssen versehenen elektronischen Bauelement (11), z.B. einem SMD-Bauelement, und einem Bauelementträger (10), mit einer in Abstand von der Lötverbindung angeordneten Wärmequelle, mittels welcher ein Warmluftstrahl und/oder ein Infrarotstrahl auf die Lötverbindung gerichtet ist und mit einer Maske (9) zur Begrenzung dieses Strahls, dadurch **gekennzeichnet**, daß mehrere masken (9) auf einem bewegbaren maskenträger angeordnet sind, so daß jeweils eine der masken wahlweise zur Begrenzung des Wärmestrahls dienen kann, daß jede maske (9) mit einer Identifizierungsmarke versehen ist und daß eine Anzeigeeinrichtung für die Identifizierungsmarke vorhanden ist.

2. Vorrichtung nach Anspruch 1, dadurch **gekennzeichnet**, daß der maskenträger als flexibler Streifen ausgebildet ist und daß eine Auf- und Abwickelrolle (22) für den flexiblen Streifen vorhanden sind.

3. Vorrichtung nach Anspruch 1 oder 2, dadurch **gekennzeichnet**, daß der maskenträger als Drehscheibe ausgebildet ist.

4. Vorrichtung zum Herstellen oder Lösen von Lötverbindungen zwischen einem mit mehreren Anschlüssen versehenen elektronischen Bauelement (11), z.B. einem SMD-Bauelement, und einem Bauelementträger (10), mit einer in Abstand von der Lötverbindung angeordnet Wärmequelle mittels welcher ein Warmluftstrahl und/oder Infrarotstrahl auf die Lötverbindung gerichtet ist, und mit einer Maske (109) zur Begrenzung des Strahls, dadurch **gekennzeichnet**, daß diese Maske (109) eine stufenlos verstellbare Maske (109) ist, so daß deren Maskenfenster (121) an die Konturen der Bauelemente (11) angepaßt werden kann, und daß diese Maske (109) aus einem Material mit niedrigem Wärmeleitwert besteht.

5. Vorrichtung nach Anspruch 4, dadurch **gekennzeichnet**, daß die stufenlos verstellbare Maske (109) aus mindestens zwei horizontal verschiebbaren Blenden (120) besteht.

6. Vorrichtung nach Anspruch 5, dadurch **gekennzeichnet**, daß mindestens eine längs und eine quer bewegbare Blende (120) vorhanden sind.

7. Vorrichtung nach einem der Ansprüche 5 oder 6, dadurch **gekennzeichnet**, daß die Blenden (120) paarweise antiparallel verschiebbar angeordnet sind.

8. Vorrichtung nach einem der vorhergehenden Ansprüche, dadurch **gekennzeichnet**, daß die Maske (9, 109) mit einem Motorantrieb bestätigt wird.

9. Vorrichtung nach einem der Ansprüche 1 bis 8, dadurch **gekennzeichnet** daß die Maske (9, 109) aus Dünnblech besteht.

## Claims

1. Device for making or undoing soldered connections beetween an electronic component (11), e.g. a SMD component provided with several galvanic connections, and a component carrier (10), with a heat source located at a distance from the soldered connection and by means of which a heat ray or jet is directed onto said connection and with a mask (9) for defining the heat ray or jet, **characterized** in that several masks (9) are arranged on a movable mask carrier, so that in each case one of the masks can be used for defining the heat ray, that every mask (9) is provided with an indentifikation mask and that a display device is provided for the identification mask.

2. Device according to claim 1, **characterized** in that the mask carrier is constructed as flexible strips and that take-up and take-off reels (22) are provided for the flexible strips.

3. Device according to claims 1 or 2, **characterized** in that the mask carrier is constructed as a rotary plate.

4. Apparatus for making or undoing soldered connections between an electronic component (11), e.g. a SMD component provided with several galvanic connections, and a component carrier (10), with a heat source arranged at a distance from the soldered connection and by means of which a heat ray is directed onto the soldered connection and with a mask (109) for defining the heat ray, **characterized** in that a continuously adjustable mask (109) is provided, so that their mask windows (12) can be adapted to the contours of the electronic components (11), and that this mask (109) consists of a material with a low heat conductivity coefficient.

5. Device according to claim 4, **characterized** in that the continuously adjustable mask (109) comprises at least two horizontally displaceable shields (120).

6. Device according to claim 5, **characterized** in that there is at least one longitudinally movable and one transversely movable shield (120).

7. Device according to one of the claims 5 or 6, **characterized** in that the shields (120) are arranged in pairwise antiparallel displaceable manner.

8. Device according to one of the preceding claims, **characterized** in that the mask (9,109) is operated with a motor drive.

9. Device according to one of the claims 1 to 8, **characterized** in that the mask (9,109) is made from thin sheet metal.

## Revendications

1. Dispositif de pose ou de dépose de liaisons soudées entre un composant électronique (11), conçu avec plusieurs connexions, par exemple un composant SMD (Surface Mounted Device), et un élément porteur (10), avec, à distance de la liaison soudée, une source de chaleur au moyen de laquelle on dirige sur la liaison soudée un rayonnement de chaleur et/ou un rayonnement infra-rouge, ces rayonnements étant limités par un masque (9), caractérisé en ce que plusieurs masques (9) sont placés sur un porteur de masques, de telle sorte qu'à chaque fois un masque peut à la demande, servir à la limitation du rayonnement de chaleur, que chaque masque (9) est conçu avec une marque d'identification, et qu'il existe un dispositif d'introduction des indications de marquage d'identification.

2. Dispositif conforme à la revendication 1, caractérisé en ce que le porteur de masques est constitué par des bandes souples et qu'il existe des rouleaux de déroulage et d'enroulage (22) des bandes souples.

3. Dispositif conforme à la revendication 1 ou 2, caractérisé en ce que le porteur de masques est constitué par un disque tournant.

4. Dispositif pour la pose ou la dépose de liaisons soudées entre un composant électronique (11), conçu avec plusieurs connexions, par exemple un composant SMD, et un élément porteur (10) avec, à distance de la liaison soudée, une source de chaleur au moyen de laquelle on dirige sur la liaison soudée un rayonnement de chaleur et/ou un rayonnement infra-rouge, ces rayonnements étant limités par un masque (109), caractérisé en ce que ce masque (109) est réglable de façon continue, de telle sorte que la fenêtre de ce masque (121) peut être ajustée aux contours du composant (11) et que ce masque (109) est constitué d'un matériau à faible conductivité calorifique.

5. Dispositif conforme à la revendication 4, caractérisé en ce que le masque à réglage continu (109) est constitué par au moins deux diaphragmes horizontaux mobiles (120).

6. Dispositif conforme à la revendication 5, caractérisé en ce qu'il existe au moins un diaphragme mobile longitudinal et un diaphragme mobile transversal (120).

7. Dispositif conforme à la revendication 5 ou 6, caractérisé en ce que les diaphragmes (120) sont mobiles anti-parallèlement par paires.

8. Dispositif conforme à l'une des revendications ci-dessus, caractérisé en ce que les masques (9, 109) sont actionnés par moteur.

9. Dispositif conforme à l'une des revendications 1 à 8, caractérisé en ce que les masques (9, 109) sont constitués par des tôles minces.

14    14

4

1

17

7

5

5

5

2   3

15

16

16

9    6

11

8    10   12   13

Fig. 1

31

9

9

31

24

30

29

Fig. 2

39

40

3'

36

36

37

Fig. 5

Fig. 3

EP 0 315 228 B1

Fig. 4

Fig. 6

Fig. 7

Fig. 8

Fig. 9